# EUROPEAN PATENT APPLICATION

(11) **EP 4 664 691 A1**
(43) Date of publication of application: **17.12.2025**
(21) Application number: 24207226.2
(22) Date of filing: 17.10.2024
(51) Int. Cl.: H01S 5/028, H01S 5/042, H01S 5/11, H01S 5/187, H01S 5/20

(54) **PHOTON-PHOTON RESONANCE PCSEL FOR HIGH-SPEED APPLICATIONS**

(30) Priority: 11.06.2024 US 202418739625
(71) Applicant: II-VI Delaware, Inc., Wilmington, DE 19890 (US)
(72) Inventor: KOCOT, Christopher, Wilmington, DE 19890 (US); TATARCZAK, Anna, Wilmington, DE 19890 (US); CHEN, Young-Kai, Wilmington, DE 19890 (US); ENG, Julie, Wilmington, DE 19890 (US)
(74) Representative: Schmidt, Christian

(57) **Abstract**

This disclosure describes a photon-photon resonance photonic crystal surface-emitting laser (PPR PCSEL) operable in high-speed applications. The PPR PCSEL comprises a first photonics crystal section and a second photonics crystal section located at along the same fabrication layer. The first photonics crystal section is operable to out-couple light vertically. The second photonics crystal section is operable to produce a photon-photon resonance. The etched pattern in the first photonics crystal section is different than the etched pattern in the second photonics crystal section.

## Description

### BACKGROUND

Limitations and disadvantages of traditional systems and methods for photonic crystal surface-emitting lasers (PCSELs) will become apparent to one of skill in the art, through comparison of such approaches with some aspects of the present method and system set forth in the remainder of this disclosure with reference to the drawings.

### BRIEF SUMMARY

Systems and methods are provided for a photon-photon resonance PCSEL operable in high-speed applications, substantially as illustrated by and/or described in connection with at least one of the figures, as set forth more completely in the claims.

### BRIEF DESCRIPTION OF THE DRAWINGS

FIG. 1 illustrates an example side view of the vertical layer stack of a PPR PCSEL comprising two photonic crystal designs, in accordance with various example implementations of this disclosure.
FIGs. 2A and 2B illustrate example top views of the PPR PCSEL, in accordance with various example implementations of this disclosure.
FIGs. 3A and 3B illustrate example photonic crystal designs, in accordance with various example implementations of this disclosure.

### DETAILED DESCRIPTION

Vertical-cavity surface-emitting lasers (VCSELs) may be used for low-cost short-reach data center links. However, a VCSEL's achievable 3dB bandwidth may be limited. Coupled-cavity VCSELs demonstrated in literature have displayed higher bandwidths, however they are not stable over temperature and current.

Creating a high-bandwidth vertically-emitting device may be critical for low-cost high-speed application such as optical data-center links. Vertical emission enables wafer level testing which improves the cost of the solution. This disclosure relates to laser-based optical communication systems utilizing photonic crystal surface-emitting lasers (PCSELs). The photon-photon resonance (PPR) PCSEL architecture provides an opportunity for using a PPR effect to increase the resonance frequency and hence achieve higher modulation speeds.

A PCSEL PPR solution may be preferred over a coupled cavity VCSEL, since it does not require a waveguide and two different biases. Alternative laser sources which enable higher speeds are edge emitters. However, edge emitters need to be diced before testing and have worse beam quality than VCSELs and PCSELs. While high speeds may be achieved with edge emitters combined with an external modulator, or with a distributed-feedback (DFB) laser with PPR, PPR PCSELs enable direct modulation and higher bandwidths with vertical emission.

This disclosure provides a PPR PCSEL operable to increase the modulation bandwidth. By adding a second photonics crystal design, the PPR PCSEL enables a photon-photon resonance effect which results in an added resonance peak in the frequency response and hence increases the modulation bandwidth.

Applications for a PPR PCSEL comprise, for example, high speed data communication optical fiber links, such as data center links. The PPR PCSEL may be, for example, a 850 nm/940 nm source for multimode fiber infrastructure, or a 1060 nm/1310 nm source within a single mode infrastructure. These wavelengths are examples and not intended to be an exhaustive list.

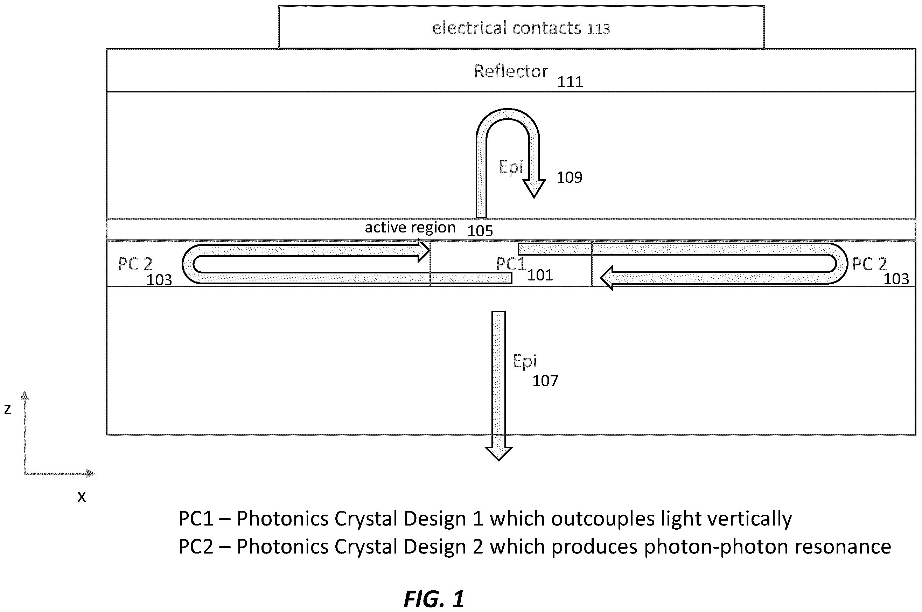

FIG. 1 illustrates an example side view of the vertical layer stack of a PPR PCSEL comprising two photonic crystal designs, in accordance with various example implementations of this disclosure.

The PPR PCSEL architecture, as shown in FIG. 1, has two PC designs. The inner photonic crystal design (PC1) 101 may be optimized for maximum vertical light emission. The outer photonics crystal design (PC2) 103 may be optimized for an optimal frequency response of the device. PC2 103 does not out-couple light in the vertical (z) direction. PC2 103 also provides lateral confinement.

The photonic crystal layer, comprising PC1 101 and PC2 103, may be fabricated using GaAs or InP with etched holes. The material and composition of PC1 101 and PC2 103 may depend on the wavelength of interest.

The active region 105 may be composed of quantum wells (QWs) and barriers. The material may depend on the wavelength. For example, for a 940 nm wavelength, the QWs may comprise InGaAs, and the barriers may comprise GaAs or AlGaAs.

Epitaxy (epi) layers 107 and 109 may extend uniformly across PC1 101 and PC2 103, providing an ease of manufacturing of this structure. The dimensions of the PCSEL may be optimized to minimize the parasitics of this high speed device.

The reflector 111 may comprise GaAs and/or AlGaAs for shorter wavelengths. For longer wavelengths, the reflector 111 may comprise InP.

The electrical contacts 113 may be located on the top side of the bottom emitting PCSEL device.

Epi layer 107 and the photonic crystal layer, comprising PC1 101 and PC2 103, may be grown first. Holes are then etched into PC1 101 and PC2 103. Active region, 105, epi layer 109, and reflector 111 are grown after etching. A regrowth or wafer bonding process may be used.

Light may be emitted down according to the placement of the reflector 111.

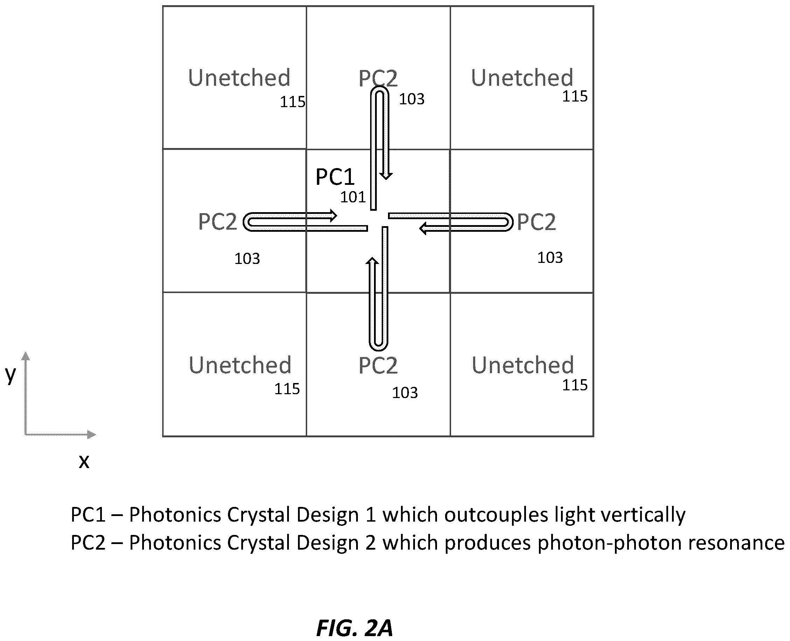

FIG. 2A illustrates a first example top view of the PPR PCSEL, in accordance with various example implementations of this disclosure.

As shown in FIG. 2A, PC2 103 may be located on up to 4 sides of PC1 101. The number of sides depends on the design and the required strength of the photon-photon resonance peak.

Unetched tiles 115 may be located in the corners. PC1 101 and PC2 103 may have different hole shapes etched in them, while corners remain without etching.

Inner photonic crystal (PC1) dimensions may range from 1 µm - 100 µm. The dimensions of PC1 are optimized to maximize the 3 dB bandwidth and power, while minimizing the parasitics of the device. The outer photonic crystal (PC2) dimensions are optimized for the maximum mode confinement and photon-photon resonance. Dimensions of PC2 may range from 1 µm to 1 mm.

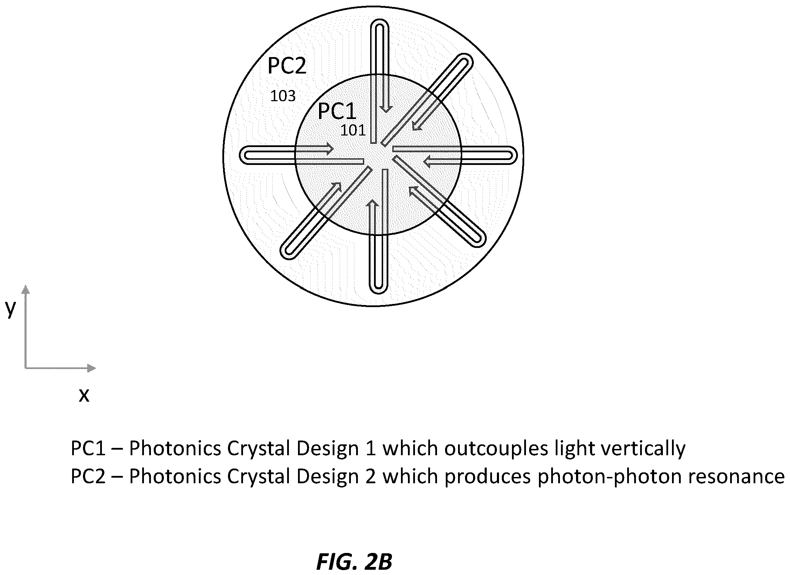

FIG. 2B illustrates a second example top view of the PPR PCSEL, in accordance with various example implementations of this disclosure.

As shown in FIG. 2B, PC2 103 may be a concentric section around a circular PC1 101 section.

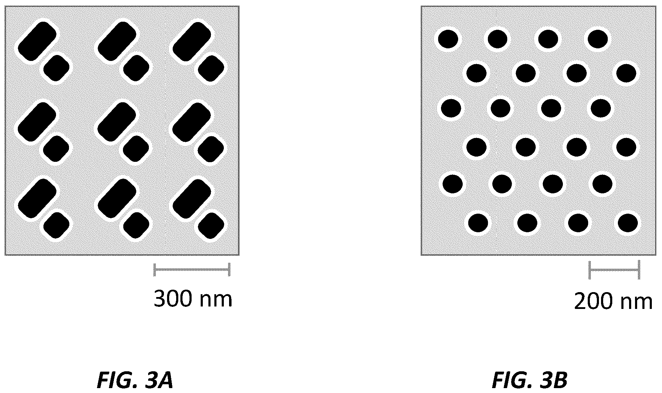

FIGs. 3A and 3B illustrate example photonic crystal (PC) designs, in accordance with various example implementations of this disclosure.

In FIGs. 3A and 3B, exemplary etched holes are shown in black. The lattice constant of a PC may be a quarter of the emission wavelength of the device. A lattice constant is defined as the distance between the etched holes. PC1 101 and PC2 103 may comprise PC designs as illustrated in FIGs. 3A and 3B. Alternative, hole shapes, sizes and placements are also possible. The PC2 is configured to provide optical feedback and phase locking between the dominant modes due to the carrier-photon resonance (CPR) and photon-photon resonance (PPR). The frequency difference between these modes should be large to maximize the 3 dB bandwidth of the device. The PC1 and PC2 are also configured for achieving a flat modulation response between the CPR and PPR. The PC2 lattice is further configured for maximum lateral mode confinement to reduce the parasitic capacitance of the PC1 section and as a result to enhance the 3 dB bandwidth.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. A laser device, comprising:
   a first photonics crystal section operable to out-couple light in a vertical direction; and
   a second photonics crystal section operable to produce a photon-photon resonance in a horizontal direction.
2. The laser device of aspect 1, wherein:
   the first photonics crystal section comprises a first etched pattern, and
   the second photonics crystal section comprises a second etched pattern that is different than the first etched pattern.
3. The laser device of aspect 1, wherein:
   the first photonics crystal section and the second photonics crystal section are located at a same fabrication layer.
4. The laser device of aspect 1, wherein the laser device comprises:
   an epitaxy layer operably coupled to the first photonics crystal section and the second photonics crystal section.
5. The laser device of aspect 1, wherein the laser device is a photon-photon resonance photonic crystal surface-emitting laser (PPR PCSEL).
6. The laser device of aspect 1, wherein the laser device is a bottom-emitting laser.
7. The laser device of aspect 1, wherein the laser device comprises:
   an active layer operably coupled to the first photonics crystal section and the second photonics crystal section.
8. The laser device of aspect 7, wherein the laser device comprises:
   an epitaxy layer operably coupled to the active layer.
9. The laser device of aspect 8, wherein the laser device comprises:
   a reflector operably coupled to the epitaxy layer.
10. The laser device of aspect 1, wherein the laser device comprises:
   a plurality of second photonics crystal sections, wherein:
   each second photonics crystal section is operable to produce a photon-photon resonance in a horizontal direction.
11. A method of fabricating a laser device, comprising:
   fabricating a first photonics crystal section operable to out-couple light in a vertical direction; and
   fabricating a second photonics crystal section, operably coupled to the first photonics crystal section, operable to produce a photon-photon resonance in a horizontal direction.
12. The method of aspect 11, wherein:
   etching the first photonics crystal section according to a first etched pattern, and
   etching the second photonics crystal section according to a second etched pattern that is different than the first etched pattern.
13. The method of aspect 11, wherein:
   the first photonics crystal section and the second photonics crystal section are located at a same fabrication layer.
14. The method of aspect 11, wherein the method comprises:
   fabricating an epitaxy layer prior to fabricating the first photonics crystal section and the second photonics crystal section.
15. The method of aspect 11, wherein the laser device is a photon-photon resonance photonic crystal surface-emitting laser (PPR PCSEL).
16. The method of aspect 11, wherein the laser device is a bottom-emitting laser.
17. The method of aspect 11, wherein the method comprises:
   fabricating an active layer atop the first photonics crystal section and the second photonics crystal section.
18. The method of aspect 17, wherein the method comprises:
   fabricating an epitaxy layer atop the active layer.
19. The method of aspect 18, wherein the method comprises:
   fabricating a reflector operably atop the epitaxy layer.
20. The method of aspect 11, wherein the method comprises:
   fabricating a plurality of second photonics crystal sections, wherein:
   each second photonics crystal section is operable to produce a photon-photon resonance in a horizontal direction.

The present disclosure claims priority of U.S. Patent Application No. US 18/739,625 filed on June 11, 2024. The entire disclosure of this application is hereby explicitly incorporated by reference into the present disclosure.

Implementations described herein may relate to the following: This disclosure describes a photon-photon resonance photonic crystal surface-emitting laser (PPR PCSEL) operable in high-speed applications. The PPR PCSEL comprises a first photonics crystal section and a second photonics crystal section located at along the same fabrication layer. The first photonics crystal section is operable to out-couple light vertically. The second photonics crystal section is operable to produce a photon-photon resonance. The etched pattern in the first photonics crystal section is different than the etched pattern in the second photonics crystal section.

As used herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As used herein, "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}. As used herein, the term "exemplary" means serving as a non-limiting example, instance, or illustration. As used herein, the terms "e.g.," and "for example" set off lists of one or more non-limiting examples, instances, or illustrations. As used herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.). As used herein, the term "based on" means "based at least in part on." For example, "x based on y" means that "x" is based at least in part on "y" (and may also be based on z, for example).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A laser device, comprising:
a first photonics crystal section operable to out-couple light in a vertical direction; and
a second photonics crystal section operable to produce a photon-photon resonance in a horizontal direction.

2. The laser device of claim 1, wherein:
the first photonics crystal section comprises a first etched pattern, and
the second photonics crystal section comprises a second etched pattern that is different than the first etched pattern.

3. The laser device of claim 1 or 2, wherein:
the first photonics crystal section and the second photonics crystal section are located at a same fabrication layer.

4. The laser device of any one of claims 1 to 3, wherein the laser device comprises:
an epitaxy layer operably coupled to the first photonics crystal section and the second photonics crystal section.

5. The laser device of any one of claims 1 to 4, wherein the laser device is a photon-photon resonance photonic crystal surface-emitting laser (PPR PCSEL).

6. The laser device of any one of claims 1 to 5, wherein the laser device is a bottom-emitting laser.

7. The laser device of any one of claims 1 to 6, wherein the laser device comprises:
an active layer operably coupled to the first photonics crystal section and the second photonics crystal section.

8. The laser device of claim 7, wherein the laser device comprises:
an epitaxy layer operably coupled to the active layer.

9. The laser device of claim 8, wherein the laser device comprises:
a reflector operably coupled to the epitaxy layer.

10. The laser device of any one of claims 1 to 9, wherein the laser device comprises:
a plurality of second photonics crystal sections, wherein:
each second photonics crystal section is operable to produce a photon-photon resonance in a horizontal direction.

11. A method of fabricating a laser device, comprising:
fabricating a first photonics crystal section operable to out-couple light in a vertical direction; and
fabricating a second photonics crystal section, operably coupled to the first photonics crystal section, operable to produce a photon-photon resonance in a horizontal direction.

12. The method of claim 11, wherein:
a) etching the first photonics crystal section according to a first etched pattern, and
etching the second photonics crystal section according to a second etched pattern that is different than the first etched pattern, and/or
b) the first photonics crystal section and the second photonics crystal section are located at a same fabrication layer, and/or
c) the laser device is a photon-photon resonance photonic crystal surface-emitting laser (PPR PCSEL), and/or
d) the laser device is a bottom-emitting laser, and/or
e) fabricating a plurality of second photonics crystal sections, wherein:
each second photonics crystal section is operable to produce a photon-photon resonance in a horizontal direction.

13. The method of claim 11 or 12, wherein the method comprises:
fabricating an epitaxy layer prior to fabricating the first photonics crystal section and the second photonics crystal section.

14. The method of any one of claims 11 to 13, wherein the method comprises:
fabricating an active layer atop the first photonics crystal section and the second photonics crystal section.

15. The method of claim 14, wherein the method comprises:
fabricating an epitaxy layer atop the active layer, wherein the method optionally comprises:
fabricating a reflector operably atop the epitaxy layer.
